# EUROPEAN PATENT SPECIFICATION

(11) **EP 3 819 111 B1**
(45) Date of publication and mention of the grant of the patent: **10.04.2024**
(21) Application number: 20205428.4
(22) Date of filing: 03.11.2020
(51) Int. Cl.: B30B 11/02, B30B 15/30, H05K 3/12

(54) **ULTRASONIC CONSOLIDATION OF PARTICULATES IN INK FOR FUNCTIONAL COATINGS**
ULTRASCHALLVERFESTIGUNG VON PARTIKELN IN TINTE FÜR FUNKTIONELLE BESCHICHTUNGEN
CONSOLIDATION ULTRASONIQUE DE PARTICULES DANS UNE ENCRE POUR REVÊTEMENTS FONCTIONNELS

(30) Priority: 05.11.2019 US 201916674361
(43) Date of publication of application: 12.05.2021
(73) Proprietor: TE Connectivity Solutions GmbH, 8200 Schaffhausen (CH); TE Connectivity Germany GmbH, 64625 Bensheim (DE)
(72) Inventor: Gulsoy, Gokce, Fremont, CA 94555 (US); Wu, Yiliang, Fremont, CA 94555 (US); Sachs, Soenke, 64625 Bensheim (DE); Gregor, Christian Walter, 64625 Bensheim (DE); Soneja, Shallu, Fremont, CA 94555 (US); Schmidt, Helge, 64625 Bensheim (DE); Greiner, Felix, 64625 Bensheim (DE)
(74) Representative: Johnstone, Douglas Ian

(56) References cited:
- WO-A1-01/20534
- WO-A1-2008/094624
- WO-A1-2011/140085
- US-A1- 2006 087 399

## Description

### FIELD OF THE INVENTION

The present invention is directed to a process in which particulates in ink are ultrasonically consolidated at ambient temperature in less than 5 seconds resulting in a completely densified, well adhered coating which can be used for various applications, such as electrical components.

### BACKGROUND OF THE INVENTION

Consolidation processes rely upon the application of chemical, mechanical or thermal energy to consolidate and achieve bonding between two materials. Conventional consolidation methods include sintering, extrusion, rolling and hot isotactic pressing. All these conventional methods require a high temperature to achieve consolidation as well as high pressure to produce a consolidated material. Exposure of substrates to high temperatures for long periods of time affects the dimensional stability and/or material microstructure of the substrates and many times precludes the use of the process with materials such as plastics and metals, such as for example copper, which can be affected by high temperatures. In addition, many of these conventional processes need to be carried out in a protective atmosphere or vacuum. Sometimes hot air flow is needed during conventional consolidation methods. Additionally, some conventional processes may necessitate the use of flux to remove oxides, to provide good adhesion or to form an alloy of one material to another. Because of these requirements, these methods are often capital cost intensive and time consuming.

Ultrasonic welding is another used industrial technique that facilitates joining of dissimilar materials. Conventional ultrasonic welding is generally used to weld plastic and/or metal sheets to plastic and/or metal sheets or metal wires/cables to metal sheets or metals wires/cables to other wires/cables.

U.S. Patent Application Publication No. US 2010/0003158 describes a vibratory powder consolidation process that uses powders. The publication describes a process in which a powder is consolidated by application of high frequency vibrations while the powder is maintained under static compressive loading in a mold to form sheet like material. The loadings are in the range of about 1034 bar to about 2068 bar (about 15,000 to about 30,000 psi). The powder is heated prior to the consolidation to a temperature between one-third and two-thirds of a melting point in degrees Kelvins of the powder material. The powders are consolidated under a uniaxial pressure by the application of ultrasonic vibration which causes high strain rate deformation in the powder particles resulting in consolidation to form a foil. These processes are time intensive. High temperature and pressures are necessary to obtain useful stand-alone structure/foils and therefore limit the applicability of this process. Compacts which are not subject to high temperatures and pressures using this ultrasonic welding of powders method do not keep their integrity and shred into powders. WO2011/140085 describes various other examples of processes for sintering nanoparticle-containing inks and powders onto flexible substrates to form thin conductive lines.

It would, therefore, be beneficial to provide a process in which particulates can be positioned and/or aligned on a substrate surface in the form of an ink and are ultrasonically consolidated at ambient temperatures and low pressures, rapidly resulting in completely densified, well adhered coatings, preferably having a sub-millimeter thickness. It would also be beneficial to provide a product made by a process in which particulates in ink are ultrasonically consolidated at ambient temperatures and low pressures, rapidly resulting in a product with a completely densified, well adhered coating.

### SUMMARY OF THE INVENTION

The invention provides a process for consolidating particulates in an ink to form a dense well adhered coating having a thickness of about 1 micron to about 50 microns, the process comprising: formulating the ink; selectively applying the ink to a substrate comprising a metal, a ceramic, a ceramic coated with a plastic or a metal coated with a plastic; drying the ink on the substrate; and ultrasonically consolidating the particulates at ambient temperature and a static pressure of about 7 kPa to about 550 kPa to form a dense, well adhered coating on the substrate in less than 5 seconds.

Other features and advantages of the present invention will be apparent from the following more detailed description of the preferred embodiment, taken in conjunction with the accompanying drawings which illustrate, by way of example, the principles of the invention.

### BRIEF DESCRIPTION OF THE DRAWINGS

FIG. 1 is a flow diagram illustrating the two- step process to ultrasonically consolidate particulates in ink to form a dense, well adhered coating under ambient temperature.
FIG. 2 is a schematic representation of an analog printing method such as roll coating, gravure printing or flexographic printing which can be used to apply ink with particulates to a substrate prior to ultrasonic consolidation.
FIG. 3 is a schematic representation of another analog printing method such as screen printing or stencil printing which can be used to apply ink with particulates to a substrate prior to ultrasonic consolidation.
FIG. 4 is a schematic representation of another analog printing method, known as pad printing, which can be used to apply ink with particulates to a substrate prior to ultrasonic consolidation of the particulates in the ink to form a coating.
FIG. 5 is a schematic representation of a digital printing method, such as dispense jet, aerosol jet and inkjet, which can be used to apply ink with particulates to a substrate prior to ultrasonic consolidation of the particulates in the ink to form a coating.
FIG. 6 is a schematic representation of an ultrasonic weld system with a sonotrode which can be used in the process of the invention.
FIG. 7 is a schematic representation of the process of the invention in which analog printing method is used in conjunction with a longitudinal welding system with a sonotrode.
FIG. 8 is a schematic representation of the process of the invention in which a digital printing method is used in conjunction with a longitudinal welding system with a sonotrode and a cap to form a dense, well adhered coating on a substrate.
FIG. 9 is a schematic representation of the process which ultrasonically consolidates particulates in ink using torsional welding.
FIG. 10 is a schematic representation of ultrasonic consolidation of ink particulates in a roll to roll process using a seam welder.
FIG. 11 is schematic representation of the process of the invention in which tin particulates in ink are ultrasonically consolidated on a copper substrate to form a coating that is densified and well adhered to the substrate.
FIG. 12 is a micrograph of ultrasonically plated tin on a copper substrate in less than 1 second according to the process of the invention.
FIG. 13 is a cross sectional view of three samples of fully densified tin on a copper- based substrate formed using the process described herein and a micrograph of each cross-sectional view.
FIG. 14 is a micrograph before consolidation of silver ink on a ceramic substrate according to the invention.
FIG. 15 is a micrograph after consolidation of silver ink on a ceramic substrate according to the invention.
FIG. 16 is a micrograph of silver ink on a ceramic substrate that was processed using conventional sintering methods at 850 °C for sixty minutes.

### DETAILED DESCRIPTION OF THE INVENTION

The description of illustrative embodiments according to principles of the present invention is intended to be read in connection with the accompanying drawings, which are to be considered part of the entire written description. In the description of embodiments of the invention disclosed herein, any reference to direction or orientation is merely intended for convenience of description and is not intended in any way to limit the scope of the present invention. Relative terms such as "lower," "upper," "horizontal," "vertical," "above," "below," "up," "down," "top" and "bottom" as well as derivative thereof (e.g., "horizontally," "downwardly," "upwardly," etc.) should be construed to refer to the orientation as then described or as shown in the drawing under discussion. These relative terms are for convenience of description only and do not require that the apparatus be constructed or operated in a particular orientation unless explicitly indicated as such. Terms such as "attached," "affixed," "connected," "coupled," "interconnected," and similar refer to a relationship wherein structures are secured or attached to one another either directly or indirectly through intervening structures, as well as both movable or rigid attachments or relationships, unless expressly described otherwise.

Moreover, the features and benefits of the invention are illustrated by reference to the preferred embodiments. Accordingly, the invention expressly should not be limited to such embodiments illustrating some possible non-limiting combination of features that may exist alone or in other combinations of features, the scope of the invention being defined by the claims appended hereto.

A process is provided which ultrasonically consolidates particulates positioned and/or aligned on a substrate at ambient temperatures providing for dense well adhered functional coatings on a substrate. The particulates can be in the form of an ink. The functional coatings can be used for electrical components. For example, the functional coatings can be used as contact finishes for connectors. Similarly, the coatings can be used as full density traces on ceramics/printed circuit boards for sensor applications or antenna applications. In addition, the functional coatings can be used as wear resistant coatings for electronic devices.

The process of the invention provides for improved conductivity of a coating at a lower temperature. In addition, due to the complete densification of the coating, improved bulk electrical and thermal conductivity can be achieved as compared to conventional consolidation methods. Finally, the process of the invention provides for improved adhesion between the coating and substrate when processed quickly and under ambient conditions.

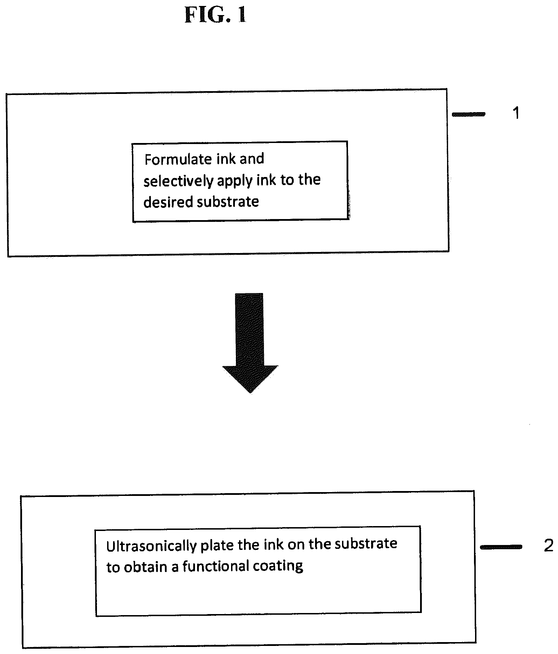

The process can be either a batch type process or a roll to roll process. Whether the process is implemented as a batch type process or a roll to roll process, there are two main steps needed to ultrasonically consolidate the particulates in ink to achieve a dense, well adhered functional coating. In the first step, the ink is formulated and applied selectively to a desired substrate and then dried on the substrate. If desired, the ink may be applied to the substrate in a patterned form. In the second step, ultrasonic plating occurs. A flow diagram illustrating the two-step process to ultrasonically consolidate particulates in ink can be found in FIG. 1.

The first step of the process 1, the ink is formulated and applied selectively to a desired substrate and then dried on the substrate. Inks which can be used in the process include any ink with particulates, preferably metal particulates. The particulates can be in any shape such as flakes, spherical or dendritic powders or nano-powders. The particulates can be in any suitable size, for example, nanoparticles, micron particles or mixtures thereof. The particulates are preferably tin, tin-zinc, silver, silver palladium, gold, aluminum, titanium, copper, silver-platinum, palladium, their alloys and the like. These particulates are dispersed in a binder and/or solvent. Any suitable materials can be used as the binder. Examples of binders can be polymers, oligomers, glass and the like. Examples of polymer binders can be polyester, polyamide, polyimide, epoxy polymer, phenoxy polymer, polyether, cellulose, polycarbonate, acrylate polymer, polyurethane, polyolefin, styrene polymers and the like. Any suitable solvents can be used for the ink formulation. Examples of solvents include alcohol, acetate, ketone, ether, water, aliphatic or aromatic hydrocarbon, and the like. Other additives such as dispersants, surfactants, leveling agents, deforming agents, rheology modifiers and the like can be added to the ink as well. The particulates can be more than 20%, or more than 30%, or more than 50%, or more than 70% by weight of the ink. The particulates can be less than 95%, or less than 90%, or less than 85% by weight of the ink. The binder can be more than 0.1%, or more than 0.5%, or more than 1 %, or more than 5% by weight of the ink. The binders can be less than 20%, or less than 10%, or less than 5%, or less than 3% by weight of the ink. The particulate to the binder ratio can be greater than 60:40, more than 70:30, more than 80:20, or more than 90:10, including more than 95:5. It is believed that the binder helps in adhering the particulates to the substrate during the processing.

The ink can also contain lubricants such as polytetrafluoroethylene (PTFE), silver monosulfide (AgS), copper sulfide (CuS), molybdenum disulfide (MoS₂), graphite particles or nanoparticles. Preferably, the lubricant can be mixed into the ink. The lubricant can be more than 0.1%, or more than 0.5%, or more than 1 %, or more than 5% by weight of the ink. The lubricant can be less than 20%, or less than 10%, or less than 5%, or less than 3% by weight of the ink. The amount of lubricant added to the ink is well within the scope of one of ordinary skill in the art in order to obtain the desired lubricating properties of the resultant coating. Similarly, to increase the hardness and wear resistance of the coating, hard particles or nanoparticles can also be added to the ink. Examples of suitable particles include aluminum oxide (Al₂ O₃), diamonds, and tungsten carbide (WC). The hard particles or nanoparticles can be more than 0.1%, or more than 0.5%, or more than 1 %, or more than 5% by weight of the ink. The hard particles or nanoparticles can be less than 20%, or less than 10%, or less than 5%, or less than 3% by weight of the ink. Nano carbon materials such as graphene and carbon nanotubes can also be added to the ink to customize the electrical conductivity or thermal performance of the coating.

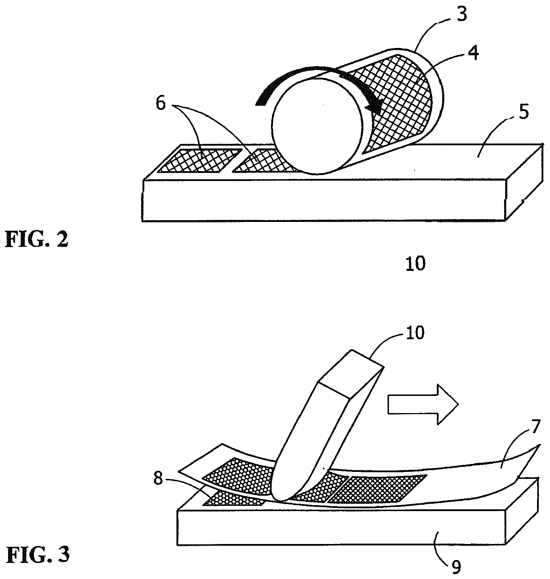

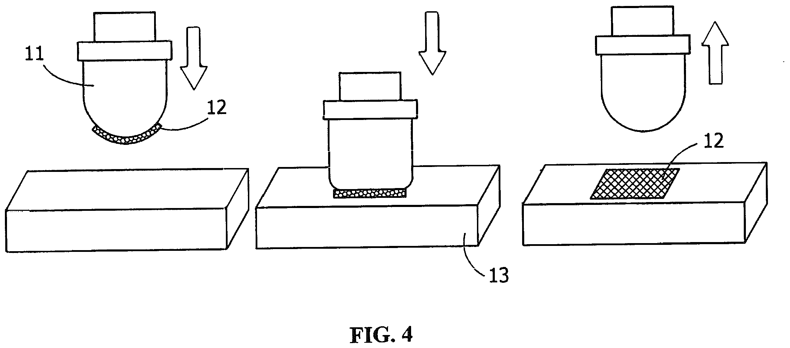

The inks can be selectively applied by either analog printing methods or digital printing methods to a desired substrate. Analog printing methods require a mask, screen or patterned roll. Contact needs to be established between the ink and substrate to transfer the ink to the substrate. FIG. 2 shows a schematic representation of roll coating, gravure printing or flexographic printing. In this embodiment, a patterned roll coater 3, selectively applies ink 4 to a substrate 5 resulting in an area 6 of ink on the substrate. FIG. 3 shows a schematic representation of screen printing or stencil printing which can be used to apply the ink to the substrate. In this embodiment, a screen with a pattern 7 is used to deposit ink 8 on a substrate 9 by the transfer of the ink onto the substrate by a squeegee 10. FIG. 4 shows a schematic representation of pad printing. In this embodiment, a pad 11 with ink is pressed down on a substrate 13 to transfer ink from the pad to the substrate. Another analog printing method is the doctor blade method. Any of these analog printing methods can be used to apply the ink with particulates to the substrate. The specific steps and parameters of each of these specific analog printing methods would be well within the skill of one of ordinary skill in the art.

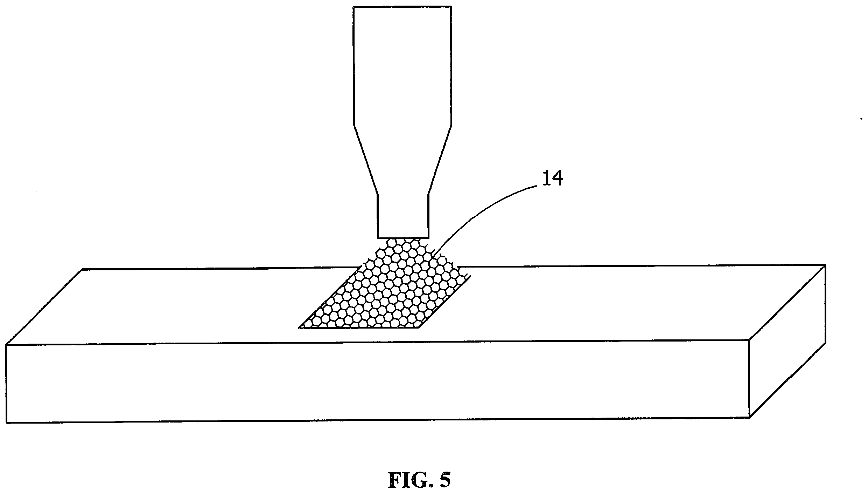

Alternatively, the ink can be selectively applied to the substrate using digital printing. Digital printing methods are maskless and the ink is generally dispensed onto the substrate with the use of a printing tool directly controlled by a computer. Examples of digital printing methods include dispense jet, aerosol jet and ink jet methods. FIG. 5 shows a schematic representation of such a method in which ink is dispensed onto the substrate.

Depending upon the method used to apply the ink, the thickness of the ink varies. If inkjet printing or aerosol jet printing are used to apply the ink, the thickness of the ink is generally in the range of about tens of nanometers to about several microns. If flexographic printing, gravure printing, pad printing, stencil printing, screen printing or dispense jet printing methods are used to apply the ink, the thickness of the ink is in the range of sub-microns to tens of microns to sub-millimeters. The amount of printed ink can be increased to the desired thickness by using the printing process repeatedly to achieve the desired thickness. The desired thickness of the ink is dependent upon the desired end application and can be easily determined by one of ordinary skill in the art.

Alternatively, using the printing processes to apply the particulates in the ink to the substrate, the particulates can be applied by any known method so that the particulates are positioned on the substrate. The particulates can then be aligned using any method to align particulates including electrostatic aligning methods.

Suitable substrates to which the ink with particulates is applied to include copper alloys, steel, stainless steel, nickel, nickel alloys, nickel plates copper, nickel plates steel, zinc, zinc alloys, aluminum and aluminum alloys, magnesium and magnesium alloys and titanium. Additionally, ceramic materials, such as alumina, zirconia, aluminum nitride and the like or plastics or metals coated with a plastic, or ceramic coated with a plastic may be used as a substrate in the process.

The second step 2 of the process of the invention as shown in FIG. 1 is the ultrasonic plating. The ultrasonic plating can be done using a metal welding press, a torsional welding press or a roll seam welding press. In this second step of the process, the ultrasonic plating process, a high strain rate plastic deformation is applied to the ink to consolidate the particulates in the ink to theoretical density at a low pressure and ambient temperature. The ultrasonic plating can be accomplished by longitudinal welding, vertical welding, torsional welding or roll seam welding.

The ultrasonic plating of the process occurs very quickly at ambient temperature. The process takes less than 5 seconds, preferably less than 2 seconds. The process occurs at ambient temperature. Ambient temperature is considered room temperature. There is no external heating applied during the process to achieve the ultrasonically plated coating. Although no external heat is necessary to achieve the desired results, localized heat may be generated within the particulates in the ink. It is believed that the localized heat generated falls in the range of slightly above room temperature to about 0.8-0.9 times the melting point of the particulates in the ink. The localized heating softens the materials above their cold work temperature and enhances deformation between particulates, thereby improving the diffusion between the particulates and promotion of densification/fusion of the particulates as well as adhesion of the particulates to the substrate. The process therefore occurs at a temperature much lower than the temperature required for conventional sintering, pressing or reflow processes or conventional powder ultrasonic welding processes. In addition, the resultant coating has much better adhesion to the substrate than a coating formed by conventional processes. Although not necessary, if desired the process can use external heating as an option to increase the efficacy of the ultrasonic welding.

Ultrasonic consolidation is based upon the particulates in the ink joining under high strain rate surface and cyclic deformation. Vibratory energy is transmitted to the surface of the ink through an ultrasonic welding system having a sonotrode or other high frequency transducer. With ultrasonic consolidation, full density consolidation is achieved at ambient temperatures within a very short period of time. Consolidation results from the inter-particle rubbing action caused by imposing high frequency vibrations. As a result of the vibrations, oxide- free particle surfaces are produced, particles deform and join. Consolidation initiates at the surface of the ink facing the sonotrode tool tip through which the vibratory energy is transmitted to the ink. Full densification occurs while deformation enhanced diffusion facilitates interparticle joining at ambient temperatures. During the process, the native oxide layers and surface films on the substrate are broken down and a perfect metallurgical bond is formed between the particulates in the ink and the substrate surface. The high strain rate deformation gives rise to a high vacancy concentration which promotes consolidation through enhanced rates of mass transport and phase transformation.

The process of the invention completely densifies the particulates in the ink onto the substrate at near theoretical density above 90 vol%, preferably above 95 vol%, most preferably above 99 vol %, including above 99.9 vol % to form a coating layer to the desired thickness as described above. In other words, the conductive layer formed by the process for consolidating particulates in an ink has a porosity less than 10 vol %, less than 5 vol %, preferably less than 1 vol %, including less than 0.1 vol %. The ultrasonically consolidated coating has a thickness of greater than 1 micron. The ultrasonically consolidated coating has a thickness of less than 50 microns, or less than about 25 microns. The thickness of the coating is dependent upon the ink, the particulates in the ink, and, the substrate as well as the desired end application.

Moreover, the process of the invention results in a coating having improved conductivity of at least 50% compared to conventional processes. Furthermore, using the process of the invention, it is believed that the conductivity of the coating can be improved almost 100% compared to coatings formed according to conventional processes.

Ultrasonic plating can also break down other detrimental species on substrate surfaces. Examples of such detrimental species include dust, dirt, native oxides, tarnish layers, nickel silicides on copper nickel silicon substrates and corrosion protection coatings such as benzotriazole.

Upon completion of the ultrasonic welding process and consolidation of the particulates in the ink, the coating contains less than 1 % organic materials. In addition, the adhesion strength of the coating to the substrate is substantially higher than the adhesion strength of a conventional sintered coating. The adhesion is improved by breaking down the surface films on the surface of the substrate by creating a physical bond between the substrate and the coating.

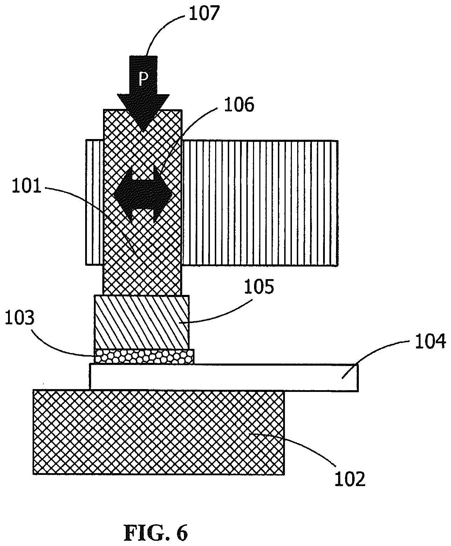

Any conventional ultrasonic welding system can be used in the process of this invention. One embodiment of an ultrasonic welding system suitable for use to ultrasonically consolidate particles in the ink according to the process of the invention is shown schematically in FIG. 6. This system includes a sonotrode 101 and anvil 102. The sontrode can have a tip. A selectively printed ink film 103 is placed onto a desired substrate 104 using either an analog or a digital printing process as described herein. The substrate with the selectively applied ink film is moved onto the anvil 102. The sonotrode 101 is then placed into contact with the surface of the ink 103, either directly, or indirectly through an optional cap 105, and oscillates horizontally 106 or in a direction parallel to the ink to apply ultrasonic vibrations to the ink. This is longitudinal welding. Alternatively, the sonotrode can also oscillate vertically, torsionally or in a rocking/rolling movement which will be described below in further detail.

The sonotrode also applies a static pressure on the ink (shown as 107), normal to the ink surface as indicated by arrow. The sonotrode is coupled with an appropriate coupling to a transducer and compression assembly to provide high frequency electric energy for transformation to mechanical energy and to provide uniaxial static compression as known in the art.

During the process of this invention, the sonotrode frequency ranges from about 15 to about 60 kilohertz, preferably 40 kilohertz. The amplitude typically ranges from about 8 to about 100 microns without a load. The amplitude with a load is about 1 micron. Preferably, the amplitude ranges from 20 to 40 microns. The peak power of the unit ranges from 1 to about 10,000 watts. Preferably, the peak power is in the range of 250 to 1500 watts. The duration of the vibration occurs from about 0.1 to about 5 seconds, preferably less than 2 seconds.

A controller may be provided to control the sonotrode system to achieve the desired process parameters, such as frequency, amplitude, pressure, and time. The system can also include appropriate sensors such as thermocouples, pressure transducers and strain gauges to measure compression and shear stress. The sensors are in communication with the controller.

The sonotrode exerts a constant or static uniaxial pressure normal to the direction of vibrations. The sonotrode moves downwardly during vibration to provide constant pressure. In accordance with the invention, the pressure should be in the range of 7 to 550 kPa (0.1 to 5.5 bar or 1 to 80 psi), preferably 14 to 414 kPa (2 to 60 psi), 21 to 345 kPa (3 to 50 psi) preferably, less than 310kPa (3.1 bar or 45 psi).

The sonotrode can be made of any materials, such as steel, for example. The sonotrode tip should preferably be made of material which does not stick to the ink. Preferably the tip is coated with a non-stick material.

The cavity for the substrate is supported by a rigid supporting fixture that is capable of absorbing the pressure and vibratory forces exerted on the ink. The cavity can be any suitable size and shape depending upon the desired finished part or alternatively, can be adjustable for various different desired finished parts.

The optional cap 105 that can be used in the process of the invention depends upon the ink as well as the substrate composition. Examples of suitable cap materials include aluminum, copper, steel, nickel, and their alloys as well as ceramics. Ceramics having higher thermal conductivity are preferable. Examples of such preferred ceramics include aluminum nitride, aluminum oxide, and silicon nitride. The cap is beneficial to control the surface finish of the coating. The smoother the cap, the smoother the finish of the coating. Preferably a material is chosen for the cap so that it prevents the ink from sticking to the sonotrode itself.

The cap can also be used to emboss wave like structures or pits that are advantageous to increase contact resistance and improve friction behavior. Moreover, the cap can also be used to emboss information onto the end product. Examples of possible information include logos, product identification or serial numbers.

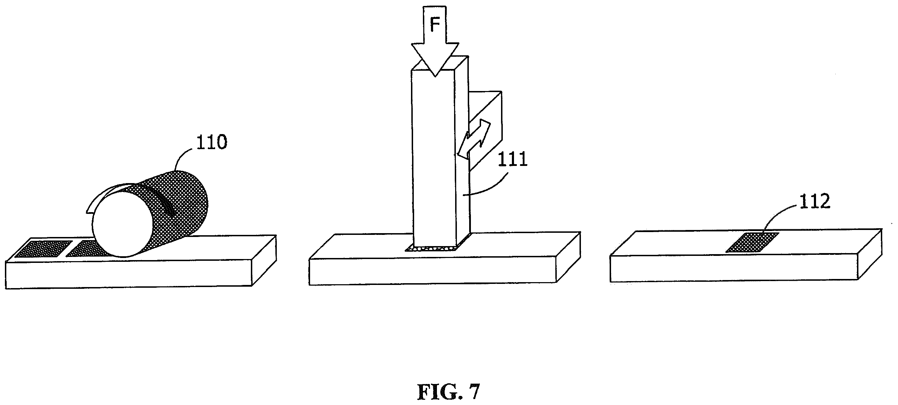

FIG. 7 shows the use of the process in conjunction with analog printing and longitudinal welding. In this schematic representation, ink is applied by an analog printing method such as roll coating 110. Once the ink with particulates is applied, the substrate with the ink is placed into the ultrasonic welding system with sonotrode 111. In this embodiment, longitudinal welding is used to ultrasonically consolidate the particulates in the ink to form the desired coating 112 on the substrate.

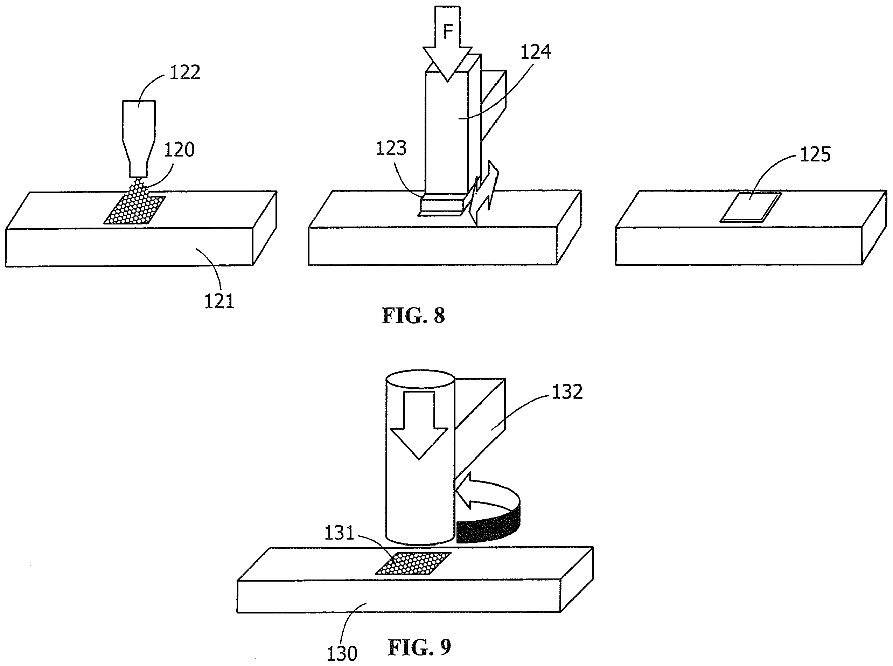

FIG. 8 shows an alternative embodiment of the process. In this schematic, the ink 120 is placed on the substrate 121 using a digital printing method 122. In the embodiment of FIG. 8, a cap 123 is placed on the ink between the ink and the substrate. Longitudinal welding using a ultrasonic welding system with a sonotrode is used to consolidate particulates in the ink to form a coating. There are many commercially available sonotrodes that can be used in this process. The determination of the desired sonotrode is well within the skill of one of ordinary skill in the art.

FIG. 9 shows yet an alternative embodiment of the process of the invention. In this schematic, the substrate 130 with the ink 131 having particulates is subject to a torsional vibration by the ultrasonic welding system 132. The sonotrode of the ultrasonic welding system vibrates with torsional motion instead of axial motion. An example of an ultrasonic welding system with a sonotrode commercially available that can be used in the process of this application is the Soniqteist torsional ultrasonic welder by Telsonic Solutions. Another alternative example of an ultrasonic welding system with a sonotrode with torsional vibration is the Powerwheel system from Telsonic Solutions. Alternatively, any sonotrode having a mixed mode of head movements can be used.

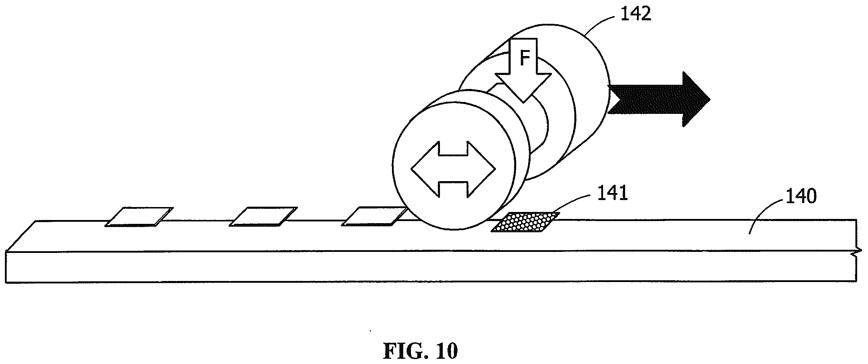

In yet another embodiment of the invention, the ultrasonic consolidation process can occur in a roll to roll process as illustrated in FIG. 10. In this embodiment, a continuous feed of substrate 140 with printed ink 141 is subject to plating to form the coating. A seam welding system can be used to accomplish this roll to roll process. An example of a commercially available seam welder is the Emerson Branson continuous seam welder. In this system, the vibratory energy is applied during the processing as the roll of the substrate with ink is drawn through the machine. This type of process results in high production rates of coatings on the substrate in mass quantities. The roll to roll process has a much higher throughput and can provide product at a lower cost than a batch process. If the roll to roll process is used in this invention, the linear speed of the process should be in the range of about 1-20 meters/minute. Preferably, the range is great than 10 meters per minute.

Using the process of this invention in which the ink is formulated and selectively applied to a substrate and dried on the substrate and then subject to vibratory consolidation allows the achievement of a dense layer of functional coating at low pressure and ambient temperatures. The thickness of the coating is about 1 micron to about 50 microns

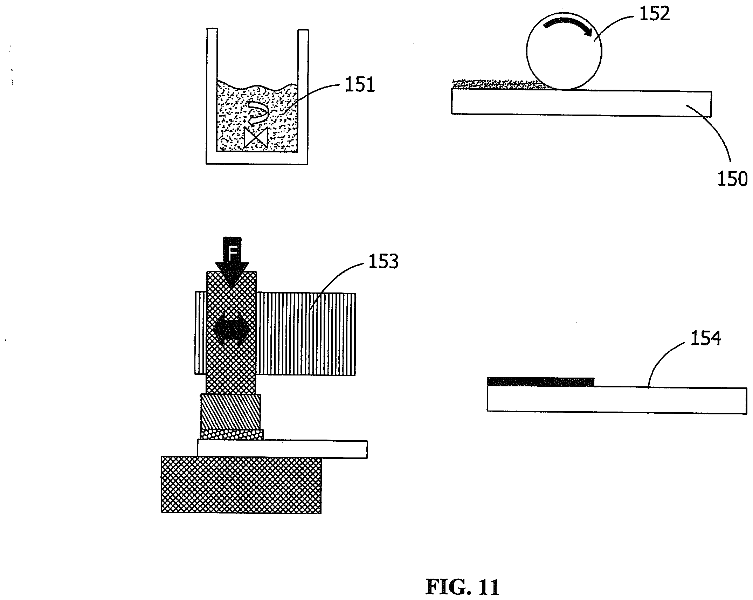

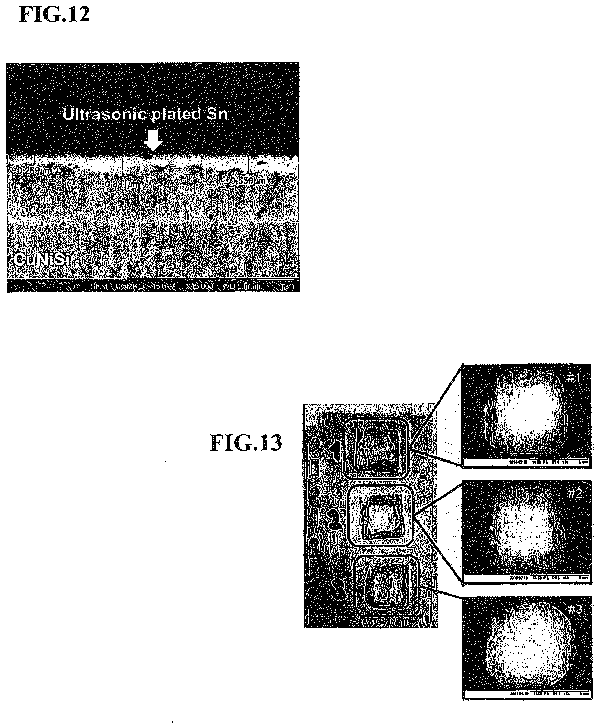

FIG. 11 shows an embodiment of the invention in which tin ink is applied to the copper substrate by gravure method, for example. The tin ink has a polymeric binder so that upon application it sticks better to the copper substrate 150. The ink is formulated 151 and applied with gravure printing 152 using a laser engraved gravure roll. Any other printing process to apply the ink to the substrate can be used and is well within the scope of one of ordinary skill in the art. The copper substrate 150 with the tin ink is subject to ultrasonic welding 153 for less than 1 second at ambient temperatures and low pressures resulting in a dense fully consolidated coating of tin on the copper substrate 154. The thickness of the coating is approximately 0.6 micrometers, measured by X-ray fluorescence spectroscopy (XFR) and has a roughness of less than 0.3 micrometers, measured by an optical profilometer. The roughness is preferably in the range of about 0.2 to about 0.3 microns. FIG. 12 is a micrograph showing full consolidation of the tin particles. The cross-sectional view of the coating as well as micrograph of the cross-sectional view in FIG. 13 shows the fully densified film and confirms the full consolidation of the coating on the substrate. The sample survived tape adhesion and bend adhesion tests showing good adhesion of the tin on the copper substrate. This process may potentially be used for metallic contact finishes such as tin, silver and gold contacts and wear resistant coatings for machine tooling, such as for example, mold/crimp tooling.

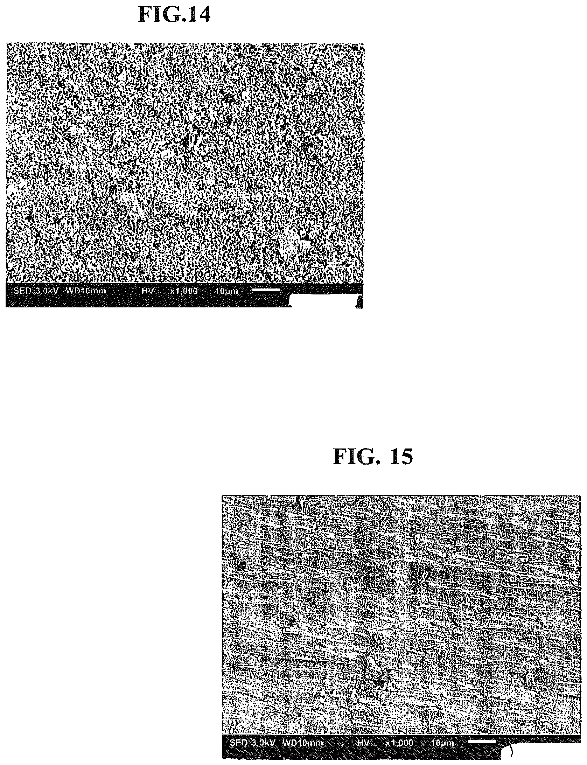

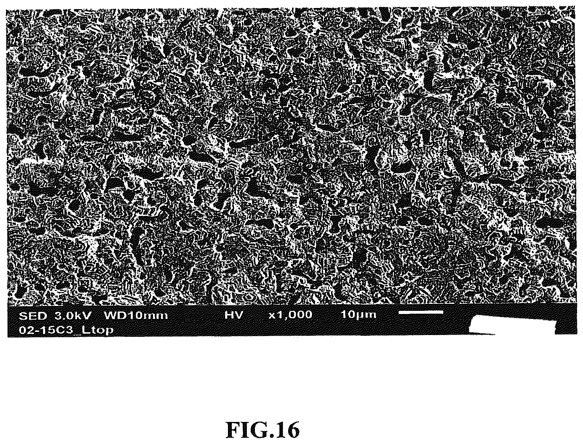

In another embodiment of the invention, silver is ultrasonically plated into aluminum nitride ceramic at room temperature in less than 5 seconds. The ceramic substrate did not fracture during the processing. The sheet resistance of the sample was less than 60 micro-ohms. The sample survived both tape and adhesion tests indicating good adhesion. FIG. 14 shows a micrograph of the sample before it was processed by ultrasonically consolidating the particulates in the ink. FIG. 15 shows a micrograph of silver ink which has formed a dense coating on the aluminum nitride at room temperature in less than 5 seconds. In contrast, FIG. 16 shows a silver ink printed onto an aluminum nitride and then sintered according to conventional methods. When compared to the dense coating in FIG. 15, the coating FIG. 16 is extremely porous. This embodiment shows the applicability of using the process of the invention for sensor applications that require coating layers that are 10 microns or greater to provide sufficiently low resistivity. Similarly, this embodiment of the process shows that the process can be used for conductive and sensing surfaces on ceramics as well as the simultaneous plating and wire/cable terminations on ceramics.

The presently disclosed embodiments are therefore to be considered in all respects as illustrative and not restrictive, the scope of the invention being defined by the appended claims, and not limited to the foregoing description or embodiments.

## Claims

1. A process for consolidating particulates in an ink to form a dense well adhered coating having a thickness of about 1 micron to about 50 microns, the process comprising:
formulating the ink (4, 8);
selectively applying the ink to a substrate (5, 9, 13) comprising a metal, a ceramic, a ceramic coated with a plastic or a metal coated with a plastic;
drying the ink on the substrate; and
ultrasonically consolidating the particulates at ambient temperature and a static pressure of about 7 kPa to about 550 kPa to form a dense, well adhered coating on the substrate in less than 5 seconds.

2. A process according to claim 1, wherein said ink (4, 8) is selectively applied to the substrate (5, 9, 13) using an analog printing method, wherein said analog print method is roll coating, gravure printing, flexographic printing, doctor blade, stencil printing, or screen printing.

3. A process according to claim 1, wherein said ink is selectively applied to the substrate using a digital printing method, wherein said digital printing method is a dispense jet method, an aerosol jet method, or an inkjet method.

4. The process according to any preceding claim, wherein said ultrasonic consolidation is completed in less than 2 seconds.

5. The process according to any preceding claim, wherein ultrasonically consolidating the particulates includes subjecting the ink (103) on the substrate (104) to a static compressive load (107) and vibratory energy.

6. The process according to any preceding claim, wherein the ultrasonic consolidation occurs at a frequency of about 15 to about 60 kilohertz, preferably wherein the ultrasonic consolidation occurs at an amplitude of about 8 to about 100 microns.

7. The process according to any preceding claim, wherein the ultrasonic consolidation occurs at peak power of about 1 to about 10,000 watts.

8. The process according to any preceding claim, wherein a cap (105, 123) is placed upon the ink (103, 120) on the substrate (104, 121) prior to ultrasonically consolidating the particulates.

9. The process according to any preceding claim, wherein said ultrasonic consolidation occurs in a metal welding press, a torsional welding press, or a roll seam welding press.

10. A process according to any preceding claim, wherein the particulates in the ink are dispersed in a binder which provides adhesion, and preferably good adhesion, to the substrate (5, 9, 13) prior to ultrasonic consolidation.

11. A process according to claim 10, wherein the coating comprises consolidated particles and the binder and has a porosity of less than 1 vol.%.

## Patentansprüche

1. Verfahren zum Verfestigen von Partikeln in einer Tinte, um eine dichte, gut haftende Beschichtung mit einer Dicke von etwa 1 Mikron bis etwa 50 Mikron zu bilden, wobei das Verfahren Folgendes beinhaltet:
Formulieren der Tinte (4, 8);
selektives Auftragen der Tinte auf ein Substrat (5, 9, 13), das ein Metall, eine Keramik, eine mit einem Kunststoff beschichtete Keramik oder ein mit einem Kunststoff beschichtetes Metall umfasst;
Trocknen der Tinte auf dem Substrat; und
Ultraschallverfestigen der Partikel bei Umgebungstemperatur und einem statischen Druck von etwa 7 kPa bis etwa 550 kPa, um in weniger als 5 Sekunden eine dichte, gut haftende Beschichtung auf dem Substrat zu bilden.

2. Verfahren nach Anspruch 1, wobei die genannte Tinte (4, 8) mit einem analogen Druckverfahren selektiv auf das Substrat (5, 9, 13) aufgebracht wird, wobei das genannte analoge Druckverfahren Walzenbeschichtung, Tiefdruck, Flexodruck, Rakel, Schablonendruck oder Siebdruck ist.

3. Verfahren nach Anspruch 1, wobei die genannte Tinte mit einem digitalen Druckverfahren selektiv auf das Substrat aufgebracht wird, wobei das genannte digitale Druckverfahren ein Dispensstrahlverfahren, ein Aerosolstrahlverfahren oder ein Tintenstrahlverfahren ist.

4. Verfahren nach einem vorherigen Anspruch, wobei die genannte Ultraschallverfestigung in weniger als 2 Sekunden abgeschlossen ist.

5. Verfahren nach einem vorherigen Anspruch, wobei das Ultraschallverfestigen der Partikel das Aussetzen der Tinte (103) auf dem Substrat (104) einer statischen Druckbelastung (107) und Vibrationsenergie beinhaltet.

6. Verfahren nach einem vorherigen Anspruch, wobei die Ultraschallverfestigung bei einer Frequenz von etwa 15 bis etwa 60 Kilohertz erfolgt, wobei die Ultraschallverfestigung vorzugsweise bei einer Amplitude von etwa 8 bis etwa 100 Mikrometern erfolgt.

7. Verfahren nach einem vorherigen Anspruch, wobei die Ultraschallverfestigung bei einer Spitzenleistung von etwa 1 bis etwa 10.000 Watt erfolgt.

8. Verfahren nach einem vorherigen Anspruch, wobei vor der Ultraschallverfestigung der Partikel eine Kappe (105, 123) auf die Tinte (103, 120) auf dem Substrat (104, 121) gesetzt wird.

9. Verfahren nach einem vorherigen Anspruch, wobei die Ultraschallverfestigung in einer Metallschweißpresse, einer Torsionsschweißpresse oder einer Rollnahtschweißpresse erfolgt.

10. Verfahren nach einem vorherigen Anspruch, wobei die Partikel in der Tinte in einem Bindemittel dispergiert sind, das vor der Ultraschallverfestigung eine Haftung, vorzugsweise eine gute Haftung, auf dem Substrat (5, 9, 13) gewährleistet.

11. Verfahren nach Anspruch 10, wobei die Beschichtung verfestigte Partikel und das Bindemittel umfasst und eine Porosität von weniger als 1 Vol.-% aufweist.

## Revendications

1. Procédé pour consolider des particules dans une encre afin de former un revêtement dense à bonne adhérence ayant une épaisseur d'environ 1 micron à environ 50 microns, le procédé comprenant :
la formulation de l'encre (4, 8) ;
l'application, de manière sélective, de l'encre à un substrat (5, 9, 13) comprenant un métal, une céramique, une céramique revêtue d'une matière plastique ou un métal revêtu d'une matière plastique ;
le séchage de l'encre sur le substrat ; et
la consolidation ultrasonique des particules à température ambiante et une pression statique d'environ 7 kPa à environ 550 kPa afin de former un revêtement dense à bonne adhérence sur le substrat en moins de 5 secondes.

2. Procédé selon la revendication 1, dans lequel ladite encre (4, 8) est appliquée de manière sélective au substrat (5, 9, 13) en utilisant un procédé d'impression analogique, ledit procédé d'impression analogique étant un revêtement au rouleau, l'héliogravure, l'impression flexographique, par une racle, l'impression au stencil, ou la sérigraphie.

3. Procédé selon la revendication 1, dans lequel ladite encre est appliquée de manière sélective au substrat en utilisant un procédé d'impression numérique, ledit procédé d'impression numérique étant un procédé de distribution par jet, un procédé par jet d'aérosol, ou un procédé à jet d'encre.

4. Procédé selon n'importe quelle revendication précédente, dans lequel ladite consolidation ultrasonique est achevée en moins de 2 secondes.

5. Procédé selon n'importe quelle revendication précédente, dans lequel la consolidation de manière ultrasonique des particules inclut le fait de soumettre l'encre (103) sur le substrat (104) à une charge compressive statique (107) et à une énergie vibratoire.

6. Procédé selon n'importe quelle revendication précédente, dans lequel la consolidation ultrasonique se produit à une fréquence d'environ 15 à environ 60 kilohertz, de préférence dans lequel la consolidation ultrasonique se produit à une amplitude d'environ 8 à environ 100 microns.

7. Procédé selon n'importe quelle revendication précédente, dans lequel la consolidation ultrasonique se produit à une puissance de crête d'environ 1 à environ 10.000 watts.

8. Procédé selon n'importe quelle revendication précédente, dans lequel une calotte (105, 123) est placée sur l'encre (103, 120) sur le substrat (104, 121) avant la consolidation de manière ultrasonique des particules.

9. Procédé selon n'importe quelle revendication précédente, dans lequel ladite consolidation ultrasonique se produit dans une presse de soudage des métaux, une presse de soudure torsionnelle, ou une presse de soudage à la molette.

10. Procédé selon n'importe quelle revendication précédente, dans lequel les particules dans l'encre sont dispersées dans un liant qui fournit l'adhésion, et de préférence une bonne adhésion, sur le substrat (5, 9, 13) avant la consolidation ultrasonique.

11. Procédé selon la revendication 10, dans lequel le revêtement comprend des particules consolidées et le liant et a une porosité de moins de 1 % en volume.
